# DEMANDE DE BREVET EUROPEEN

(11) **EP 1 496 697 A1**
(43) Date de publication de la demande: **12.01.2005**
(21) Numéro de dépôt: 04291784.9
(22) Date de dépôt: 12.07.2004
(51) Int. Cl.: H04N 5/76, H04N 5/00, G11C 7/00

(54) **Système numérique d'enregistrement de signaux vidéo**

(30) Priorité: 11.07.2003 FR 0308516
(71) Demandeur: Archos, 91430 Igny (FR)
(72) Inventeur: Crohas, Henri, 91370 Verrières-le-Buisson (FR)
(74) Mandataire: Pontet, Bernard

(57) **Abrégé**

L'invention concerne un système pour enregistrer des signaux audio/vidéo. Ce système comprend un module récepteur de signaux audio/vidéo, apte à recevoir des signaux analogiques et numériques, ce module étant doté, si nécessaire, de moyens de conversion des signaux reçus. Il comprend également une unité de stockage pour enregistrer sous forme numérique les signaux audio/vidéo provenant desdits moyens de conversion en réponse à une consigne d'enregistrement. Selon l'invention, l'unité de stockage est un lecteur portable autonome intégré de manière extractible dans ledit module récepteur et comprenant :
- des moyens de stockage numérique,
- des moyens pour restituer les signaux enregistrés,
- des moyens pour visualiser et/ou écouter les signaux audio/vidéo enregistrés, et
- des moyens d'alimentation autonome rechargeables au sein dudit module récepteur.

## Description

La présente invention se rapporte à un système pour enregistrer des signaux vidéo sous forme numérique. Elle s'applique en particulier à des terminaux de type Set-Top-Box recevant un flux de données depuis un câble ou une antenne.

Il existe de nombreux dispositifs d'enregistrement de signaux vidéo numérique qui se connectent au set-top-box. Le document US6442328 décrit un set-top-box relié d'une part de façon numérique à un enregistreur numérique doté d'un disque dur et d'autre part à un poste de télévision. Ainsi le poste de télévision peut être alimenté en temps réel par un signal provenant du disque dur et par le signal TV reçu par le set-top-box. Les moyens de connexion entre l'enregistreur numérique et le set-top-box sont tels que les séquences audio/vidéo stockées sont difficilement transportables.

Il existe par ailleurs des terminaux set-top-box dotés d'un disque dur intégré. Ainsi, le signal numérique reçu peut être directement sous forme numérique. Pour pouvoir partager les séquences audio/vidéo enregistrées, de tels terminaux comportent une connexion à Internet. Mais le transfert d'un fichier vidéo volumineux via Internet reste laborieux du fait de la bande passante limitée.

Pour améliorer la portabilité des séquences vidéo enregistrées, on connaît des dispositifs enregistrant sur des supports amovibles tels qu'un CD ou un DVD. Le document WO 03030549 décrit un set-top-box intégrant un disque dur et un lecteur/graveur CD permettant d'améliorer la portabilité du signal vidéo stocké puisque le CD ou DVD enregistré peut être facilement transporté et lu par de nombreux autres dispositifs. On augmente aussi artificiellement la capacité d'enregistrement car il suffit de remplacer le CD ou le DVD plein par un CD ou DVD vierge. On connaît également le document WO 0184826 décrivant un système vidéo à la demande sous forme d'un set-top-box associé à des moyens de stockage intégrés ou amovibles tels qu'un CD on DVD. L'utilisation de deux tuners permet d'enregistrer une chaîne alors qu'on en visualise une autre. La portabilité est également limité au fait que les séquences sont stockées dans un CD ou DVD amovible.

La présente invention a pour but un nouveau système d'enregistrement vidéo numérique dans lequel la portabilité des séquences audio/vidéo enregistrées est grandement améliorée.

On atteint le but précité avec un système pour enregistrer des signaux audio/vidéo, ce système comprenant:
- un module récepteur de signaux audio/vidéo, apte à recevoir des signaux analogiques et numériques, ce module étant doté, si nécessaire, de moyens de conversion des signaux reçus, et
- une unité de stockage pour enregistrer sous forme numérique les signaux audio/vidéo provenant desdits moyens de conversion en réponse à une consigne d'enregistrement.

Selon l'invention, l'unité de stockage est un lecteur portable autonome intégré de manière extractible dans le module récepteur. Le module récepteur comprend alors un logement adapté pour recevoir le lecteur portable. Ce logement peut recevoir partiellement le lecteur portable. Le module récepteur est alors un support.

Selon un mode de réalisation préféré de l'invention, le lecteur portable comprend :
- des moyens de stockage numérique,
- des moyens pour restituer les signaux enregistrés,
- des moyens pour visualiser et/ou écouter les signaux audio/vidéo enregistrés, et
- des moyens d'alimentation autonome rechargeables au sein du module récepteur.

Le module récepteur peut donc avantageusement comprendre des moyens de connexion pour recharger les moyens d'alimentation autonome du lecteur portable.

En particulier, les moyens de connexion entre le module récepteur et le lecteur portable peuvent comprendre un câble unique comportant un faisceau de fils conducteurs pour la transmission de signaux depuis et vers le lecteur portable; l'extrémité du câble, côté lecteur portable, comprenant un connecteur doté de plusieurs fiches destinées à venir en prise avec des fiches correspondantes du lecteur portable. Ainsi, l'entrée d'alimentation du module récepteur apte à recevoir l'alimentation du secteur via un câble d'alimentation, peut à la fois alimenter le module récepteur et alimenter le lecteur portable via ledit câble unique.

Le module récepteur peut être de type set-top-box doté d'une unité de traitement telle qu'un microcontrôleur ou un microprocesseur.

Le système selon l'invention comporte donc deux parties. Une base ou berceau ("cradle" en langue anglaise), sous forme de module récepteur, installée près des sources vidéo et connectée à l'ensemble des appareils audio/vidéo de la maison et aux sources audio/vidéo disponibles. Une seconde partie sous forme d'un lecteur portable autonome comportant une batterie ; des moyens de stockage, de préférence un disque dur, pour stocker les signaux provenant de la base ; et des moyens de restitutions tels que par exemple un convertisseur numérique-analogique, un décodeur vidéo, un écran et des enceintes. Le disque dur est de grande capacité et peut stocker jusqu'à une cinquantaine d'heures de séquences vidéo. Bien entendu, l'évolution technologique permettra d'intégrer des disques dur de capacité encore plus importante.

Le module récepteur et le lecteur portable peuvent comprendre des moyens de connexion métallique pour la communication.

Selon un mode de réalisation de l'invention, le lecteur portable comprend des moyens de communication sans fil avec le module récepteur. Dans ce cas, il n'est pas nécessaire d'insérer le lecteur portable dans le module récepteur, les séquences à enregistrer peuvent être transmises à distante et sans fil. On utilise alors le logement dans le module récepteur afin d'y insérer le lecteur portable pour une recharge de la batterie.

La communication sans fil peut donc s'effectuer lorsque le lecteur portable est inséré ou non. On peut prévoir un lecteur portable doté à la fois d'un connecteur métallique et d'un module sans fil, la communication s'effectuant automatiquement par connecteur métallique lorsque le lecteur portable est inséré, et par module sans fil lorsque le lecteur portable est hors du logement tout en restant à la portée d'un second module sans fil installé dans le module récepteur.

En communication sans fil de type Wifi (norme de communication sans fil 802.11) par exemple, le lecteur portable peut être utilisé comme télécommande Wifi pour commander le module récepteur.

Selon une caractéristique avantageuse de l'invention, le lecteur portable comprend une interface de saisie sous la forme d'un écran tactile, qui peut être utilisé comme un moyen de pointage absolu d'un objet ou d'un menu affiché sur l'écran intégré avec le doigt de l'utilisateur (fonction "touch-screen"), et qui peut être utilisé comme un pointeur de souris de type "touch-pad" lorsque l'affichage se fait sur écran TV (OSD). Dans ce dernier cas, les informations de position et de mouvement du doigt de l'utilisateur sont converties en informations de déplacement et de vitesse d'un pointeur sur l'écran pour simuler l'interface souris typique d'un PC portable.

Le module récepteur peut comprendre un module infrarouge pour recevoir des informations depuis une télécommande IR standard et éventuellement les transmettre vers le lecteur portable. L'utilisateur peut contrôler la majorité des fonctions de l'ensemble (module récepteur + lecteur portable inséré) avec cette télécommande standard : réglages, programmation d'enregistrement.

Selon un mode de réalisation avantageux de l'invention, pour les signaux de la télévision hertzienne par exemple, le lecteur portable comporte au moins un tuner. Le système dans son ensemble peut comporter un seul tuner qui est, soit disposé dans le module récepteur, dans ce cas le module récepteur peut être utilisé seul, soit disposé dans le lecteur portable, dans ce cas le module récepteur n'est utile qu'avec son lecteur portable. Le système dans son ensemble peut aussi comporter un tuner disposé dans le module récepteur et un tuner disposé dans le lecteur portable.

Avantageusement, les moyens de conversion dans le module récepteur peuvent comprendre :
- un tuner hertzien associé à un démodulateur audio pour traiter des signaux analogiques provenant d'une antenne TV reliée à une entrée du module récepteur ;
- un tuner radio pour traiter des signaux analogiques provenant d'une antenne radio reliée à une entrée du module récepteur, les deux tuners permettant d'obtenir des signaux analogiques en bande de base ;
- des moyens de décodage de signaux TV numérique reçus par le module récepteur, par exemple ces moyens permettent de convertir les signaux numériques MPEG-2 en signaux numériques non-compressés sous le format CCIR-656 (recommandation n° 656 du Comité Consultatif International des Radiocommunications (CCIR), désormais appelé ITU ("International Télécommunication Union"), soit ITU-R 656) ;
- des moyens pour convertir des signaux vidéo numériques reçus par le module récepteur, en provenance notamment d'une caméra vidéo numérique avec un format MPEG-2 spécifique, en un format tel que le numérique CCIR compatible avec le module de stockage ; et
- un convertisseur analogique-numérique pour convertir des signaux analogiques reçus par le module récepteur en signaux numériques, au format CCIR-656 par exemple, transmissibles vers le lecteur portable.

Les moyens de conversion sont alimentés par diverses sources et génèrent en sortie des signaux numériques transmissibles vers le lecteur portable.

Le système selon l'invention est donc multi-sources : TV hertzienne, TV câble, radio FM, vidéo numérique DV, vidéo analogique. L'homme du métier comprendra aisément que la présente liste n'est pas exhaustive.

Selon une variante de l'invention, le convertisseur analogique-numérique est disposé dans le lecteur portable afin de convertir des signaux analogiques provenant du module récepteur en signaux numériques destinés à être stockés. Le lecteur portable comprend en outre une entrée analogique associée à ce convertisseur analogique-numérique pour recevoir les signaux analogiques provenant du module récepteur, et une entrée numérique via un connecteur adapté pour recevoir les signaux numériques provenant du module récepteur.

Avantageusement, le lecteur portable peut comprendre des moyens de compression numérique pour compresser les signaux audio/vidéo numériques destinés à être stockés. Il peut s'agir d'un encodeur au format MPEG-4 ou Divx.

De préférence, le lecteur portable comprend des moyens de conversion aptes à convertir les signaux numériques audio/vidéo stockés en des signaux audio/vidéo lisibles par des terminaux de restitution externes, ainsi que des moyens de connexion aptes à transmettre les signaux stockés depuis le lecteur portable vers des terminaux de restitution externes. Ce lecteur peut ainsi se connecter seul directement à un poste de télévision ou une chaîne Hi-fi, ou tout autre appareil audio/vidéo.

Selon un mode de mise en oeuvre de l'invention, la consigne d'enregistrement provient d'une télécommande distante. Elle peut également provenir d'une programmation mémorisée au sein du module récepteur ou d'une programmation mémorisée au sein du lecteur portable.

D'autres avantages et caractéristiques de l'invention apparaîtront à l'examen de la description détaillée d'un mode de mise en oeuvre nullement limitatif, et des dessins annexés, sur lesquels :
- la figure 1 est une vue générale du système selon l'invention ;
- la figure 2 est un schéma illustrant différents modes d'utilisation d'un module récepteur ou set top box selon l'invention ;
- la figure 3 est une vue illustrant un mode d'utilisation du lecteur portable selon l'invention ;
- la figure 4 est une vue schématique illustrant l'association d'un lecteur portable selon l'invention avec un poste de télévision et un amplificateur Hi-fi ;
- la figure 5 est un schéma simplifié du lecteur portable intégré dans le module récepteur et quelques composants de ce module récepteur ;
- la figure 6 est un schéma simplifié illustrant quelques composants internes du lecteur portable selon l'invention;
- la figure 7 est un schéma simplifié de la connexion entre le lecteur portable partiellement intégré dans le module récepteur; et
- la figure 8 est un schéma simplifié d'une variante du mode de réalisation illustré sur la figure 7.

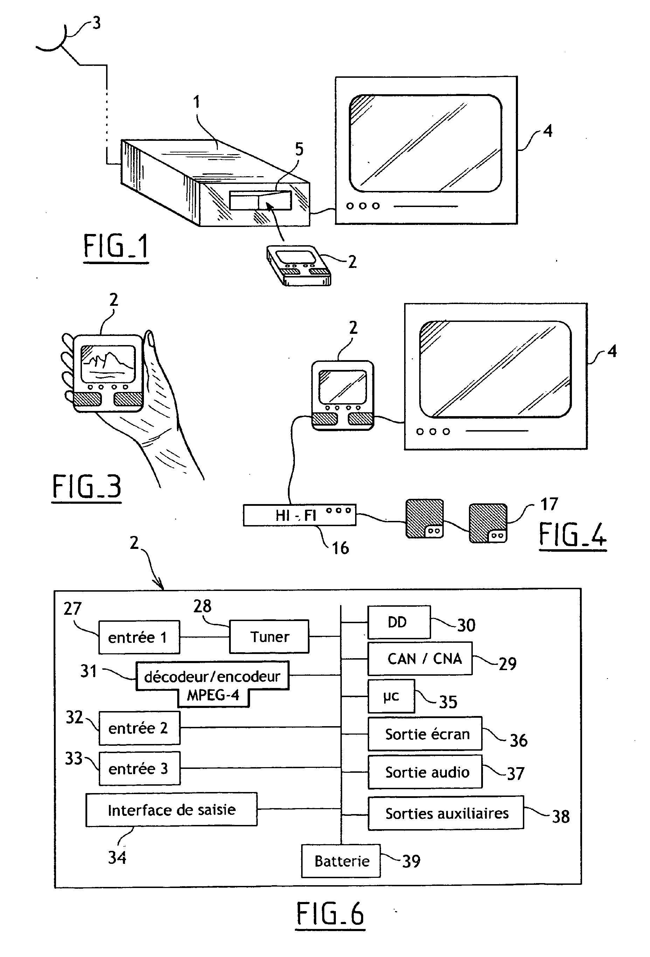

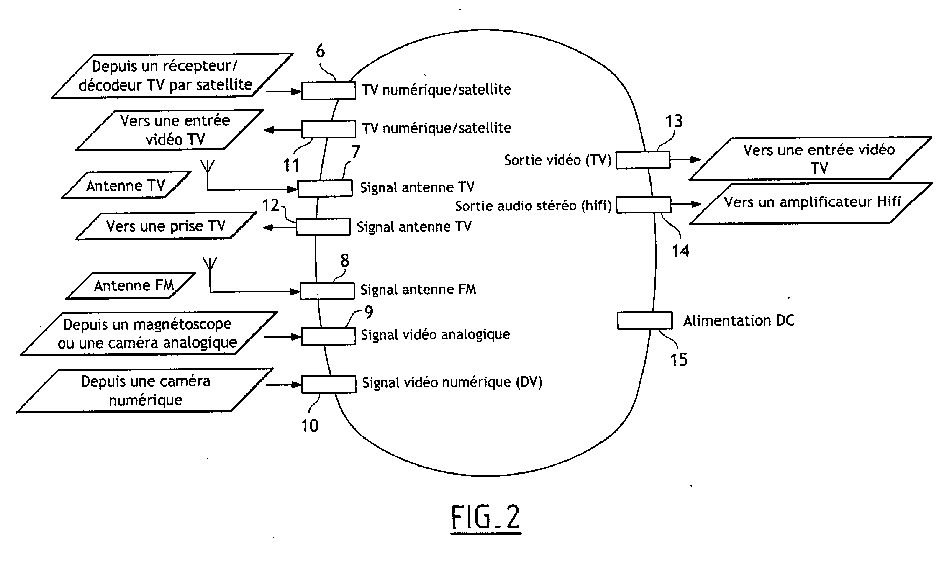

En référence à la figure 1, on voit un système vidéo selon l'invention composé d'un récepteur 1 et d'un lecteur portable autonome extractible 2. Le module récepteur 1 selon l'invention est du type set top box. Lorsqu'un signal vidéo arrivant est crypté, le module récepteur 1 comprend des moyens pour le décrypter. Comme on le verra plus en détails ci-dessus le module récepteur comprend en outre des moyens pour numériser les signaux vidéo analogiques avant de les stocker dans un disque dur. L'invention est notamment remarquable par le fait que, le disque dur prévu pour stocker le signal vidéo numérisé et disposé dans le lecteur portable 2. Pour sélectionner une source, programmer un enregistrement ou d'une façon générale configurer le système selon l'invention, on peut utiliser une interface de saisie du module récepteur (des boutons associés à un module d'affichage disposés sur une facette), une télécommande infrarouge standard ou l'écran tactile du lecteur portable. Lors de la configuration du système, une affichage de type OSD (pour "On screen Display" en langue anglaise) apparaît sur l'écran du téléviseur.

Le module récepteur 1 peut fonctionner de manière conventionnelle pour un set top box, c'est à dire réceptionner un signal vidéo provenant d'une source externe et alimenter un poste de télévision 4 avec ou sans la présence du lecteur portable 2. Mais, le système selon l'invention est multi-sources et est doté d'une fonction d'enregistrement qui, lorsqu'elle est commandée, permet d'enregistrer un signal vidéo numérique d'une source donnée dans le disque dur du lecteur portable autonome 2.

Le lecteur portable 2 est encastré dans le module récepteur 1 pour l'enregistrement. Des moyens de connexion métalliques prévus sur le lecteur portable 2 et le module récepteur 1 coopèrent les uns avec les autres de façon à permettre l'échange d'information entre les deux appareils. On prévoit également des moyens de connexion métalliques pour recharger une batterie disposée dans le lecteur portable 2 depuis une source d'alimentation du module récepteur 1 fixe.

Par ailleurs, le module récepteur 1 et le lecteur portable 2 peuvent communiquer de manière sans fil. Pour ce faire, ils intègrent des modules sans fil de type Wifi (pour "Wireless Fidelity" en langue anglaise, correspondant à la norme de communication sans fil 802.11). On utilise le logement 5 et des moyens de connexion mécaniques entre le modulo récepteur 1 et le lecteur portable 2 pour permettre la recharge de la batterie lorsque le lecteur portable 2 est inséré dans le logement 5.

Le lecteur portable 2 peut également servir de télécommande Wifi pour le module récepteur 1. Les fonctions à télécommander peuvent par exemple être la sélection d'une chaîne à visualiser en temps réel ou à enregistrer, le niveau de volume, la mise en route et en veille du module récepteur 1 ou encore la programmation de l'enregistrement. Cette programmation peut être mémorisée au sein d'une unité de traitement du module récepteur 1 ou au sein d'une unité de traitement du lecteur portable 2.

Lorsqu'une émission à été enregistrée au sein d'un disque dur du lecteur portable 2, elle peut être visualisée à tout moment au moyen du seul lecteur portable 2 comme on le voit sur la figure 3. Ce lecteur comprend des moyens d'affichage et de restitution sonore ainsi qu'une batterie d'alimentation de façon à être complètement autonome. L'émission enregistrée devient ainsi facilement transportable et accessible à tout moment et en tout lieu à partir du lecteur portable 2. Avec un disque dur de grande capacité et des algorithmes de compression en constante évolution, plusieurs dizaines d'heures de film peuvent être stockées.

L'émission enregistrée peut donc être visualisée à l'extérieur par exemple au cour d'un voyage de manière entièrement autonome, ou à l'intérieur au moyen de tout poste de télévision fixe 4 et/ou amplificateur Hi-fi 16 doté d'enceintes sonores 17 pour un plus grand confort.

Sur la figure 2, on voit un schéma simplifié d'un mode d'utilisation du module récepteur 1 selon l'invention. Ce module récepteur 1 comprend plusieurs entrées telles qu'une entrée satellite 6 pour recevoir le signal numérique provenant d'un décodeur numérique relié à une antenne satellite, une entrée analogique 7 reliée à une antenne recevant les signaux TV hertziens, une entrée analogique 8 reliée à une antenne recevant les signaux radio FM hertziens, une entrée analogique 9 recevant les signaux analogiques provenant d'une caméra analogique, et une entrée numérique DV 10 recevant des signaux numériques provenant d'une caméra numérique.

Le signal arrivant par l'entrée satellite 6 peut être redirigé vers la sortie satellite 11 pour alimenter un poste de télévision. De même le signal arrivant par l'entrée analogique 7 peut être directement dirigé vers la sortie analogique 12 reliée à un poste de télévision.

Le module récepteur 1 selon l'invention comprend également une sortie vidéo à connecter à un poste de télévision de façon à transmettre le signal vidéo provenant du lecteur portable 2. De même, on distingue une sortie audio stéréo à connecter à un amplificateur Hifi de façon à transmettre le signal audio provenant du lecteur portable 2 vers un terminal externe. On distingue également un connecteur d'alimentation 15 destiné à recharger le lecteur portable 2 lorsque ce dernier est inséré dans le module récepteur 1.

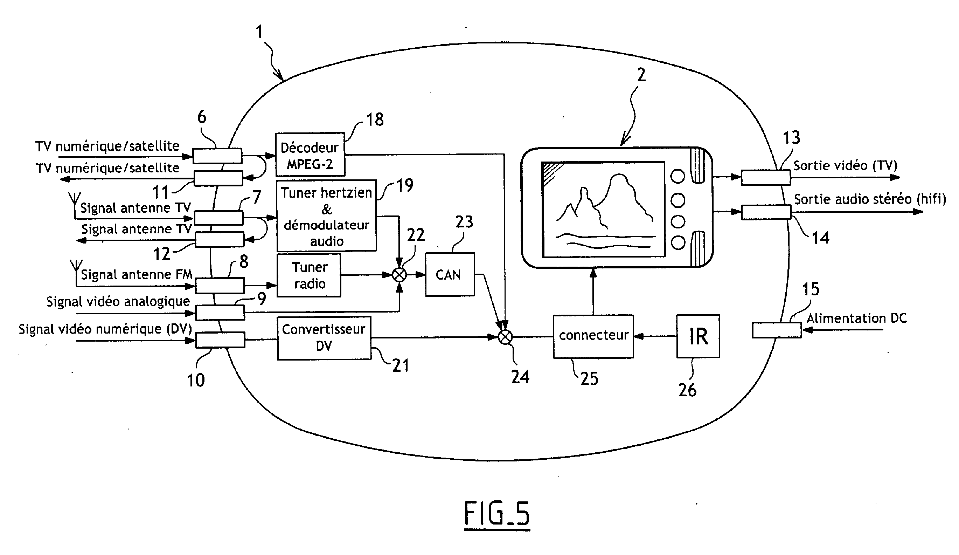

Sur la figure 5, on voit un peu plus en détail, mais de façon non limitative, quelques éléments internes du module récepteur 1 dans lequel est intégré le lecteur portable 2.

On retrouve les mêmes entrées et sorties que celles représentées sur la figure 2. Les signaux provenant des différentes entrées 6, 7, 8, 9 et 10 sont susceptibles d'être stockés sous forme numérique dans un disque dur contenu dans le lecteur portable 2. Différents formats de compression peuvent être utilisés pour stocker une grande quantité de signaux vidéo dans le disque dur. On peut notamment utiliser le format MPEG-2, MPEG-4 ou encore DIVX.

Le décodeur 18 permet de convertir les signaux numériques MPEG-2 provenant de l'entrée 6 en un signal numérique décompressé sous le format CCIR656, ce signal étant ensuite transmis vers le lecteur portable 2 pour compression et enregistrement. De même le module 21 permet de convertir des signaux numériques provenant par exemple d'une caméra numérique via l'entrée 10 en un signal numérique décompressé sous le format CCIR656.

En ce qui concerne les signaux analogiques, on utilise un convertisseur analogique-numérique 23 délivrant un signal numérique non compressé de type CCIR656. Ce convertisseur analogique-numérique est précédé d'un multiplexeur 22 recevant directement :
- un signal analogique vidéo via l'entrée 9,
- un signal analogique provenant d'un tuner radio 20 alimenté par le signal radio analogique de l'entrée 8, et
- un signal analogique provenant d'un tuner 19 alimenté par un signal analogique de la télévision hertzienne, le tuner 19 étant constitué d'un tuner hertzien et d'un démodulateur audio.

Le multiplexeur 24 est apte à véhiculer l'un des signaux numériques non-compressés des modules 18, 21 et 23 vers le disque dur du lecteur portable 2 via un connecteur 25. Ce connecteur 25 comporte une interface de type compact flash® coopérant avec un connecteur correspondant disposé dans le lecteur portable 2. L'interface du connecteur 25 avec le multiplexeur 24 est composée d'un bus pour vidéo numérique de type CCIR656 et d'un bus de commande I2C. Ce connecteur 25 comprend également une entrée infrarouge recevant les signaux d'un récepteur infrarouge 26.

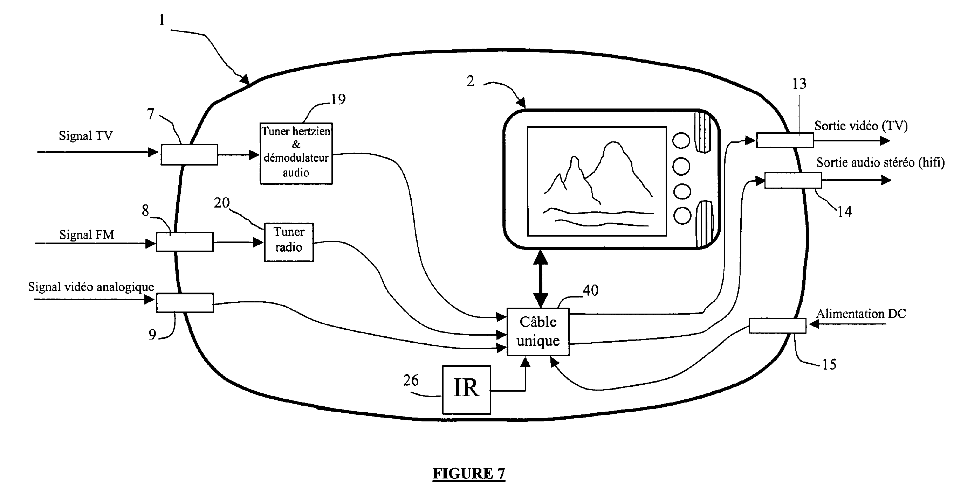

La figure 6 est un schéma simplifié non limitatif illustrant quelques composants internes du lecteur portable 2 selon l'invention. Le coeur de ce lecteur portable 2 est composé d'un microcontrôleur 35 pour traiter des données et coordonner les différents composants. On distingue une première entrée 27 qui peut recevoir un signal vidéo provenant d'une antenne TV hertzienne. Un tel signal est ensuite traité par un tuner 28 puis un convertisseur analogique numérique 29. Le signal numérique obtenu est au format non compressé CCIR656 et peut ensuite être compressé en MPEG-4 ou Divx puis enregistré dans le disque dur 30. Mais le signal sortant du tuner 28 peut être véhiculé vers l'une des sorties auxiliaires 38 de façon à alimenter un poste de télévision et/ou un amplificateur Hi-fi externe.

L'entrée 32 est celle qui est en prise avec le connecteur 25 du module récepteur 1.

L'entrée 33 est une entrée numérique recevant des signaux en provenance d'une caméra numérique par exemple.

Les signaux numériques arrivant par les entrées 32 et 33 sont d'abord compressés sous format MPEG-4 par le décodeur/encodeur 31 avant d'être stockés dans le disque dur 30.

Les signaux audio/vidéo stockés dans le disque dur 30 sont aptes à être restitués via un écran de visualisation 36 et une sortie audio 37, de sorte que l'utilisateur du lecteur portable 2 peut visualiser les émissions stockées dans le disque dur 30 en tout lieu et à tout moment.

L'ensemble du lecteur portable est alimenté au moyen d'une batterie 39 interne qui peut être rechargée lorsque le lecteur portable 2 est inséré dans le module récepteur 1.

On distingue également une interface de saisie 34 permettant de paramétrer et de commander différentes fonctions du lecteur portable 2 telle que la programmation des enregistrements, la lecture des séquences vidéo, et la sélection d'une entrée. L'interface de saisie 34 peut être associée à l'écran 36 sous la forme d'un écran tactile.

Lorsque le lecteur portable 2 est relié à un poste de télévision via une des sorties auxiliaires 38, les séquences vidéo stockées dans le disque dur 30 sont d'abord décompressées via le module 31 puis converties en signal analogique via le module 29.

La figure 7 illustre un mode de réalisation de l'invention dans lequel le lecteur portable est partiellement intégré dans le module récepteur. Ce module récepteur ne comporte quasiment pas d'intelligence et sert principalement de support pour le lecteur portable 2. Ce support peut également être portable et de petite taille de type tenant dans la main. Il est essentiellement doté d'entrées recevant des signaux analogiques. Tout ou partie de ces signaux audio/vidéo analogiques peuvent être directement transmis, comme le signal de l'entrée 9, vers le lecteur portable où ils sont traités. Certains signaux TV 7 et 8 par exemple passent par des tuners audio/vidéo 19/20 disposés dans le module récepteur 1.

Sur la figure 7, les signaux analogiques passent via un câble unique 40 pour se connecter au lecteur portable 2. Le câble unique 40 est composé de plusieurs fils conducteurs permettant :
- d'alimenter directement le lecteur portable en signaux analogiques, c'est à dire pas de conversion dans le module récepteur,
- d'alimenter en courant électrique le lecteur portable 2 à partir de l'alimentation 15,
- de transmettre les signaux infrarouge depuis le récepteur infrarouge 26 vers le lecteur portable, et
- de transmettre des signaux audio/vidéo analogiques depuis le lecteur portable 2 vers les sorties 13 et 14 du module récepteur.

Ce câble unique peut être un câble sortant à l'extérieur du module récepteur et se branchant sur des fiches correspondantes sur le lecteur portable.

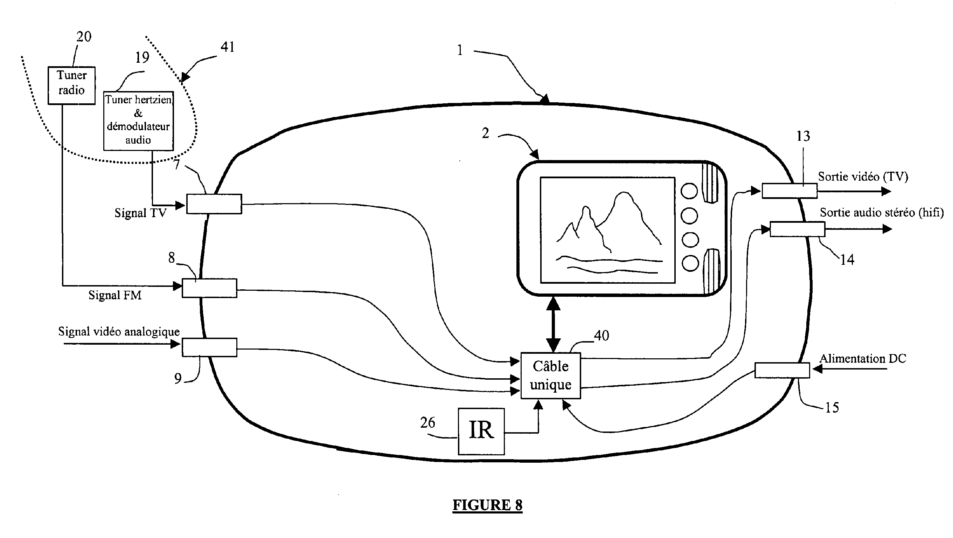

Sur la figure 8 est représenté un autre mode de réalisation avantageux de l'invention. Les éléments de la figure 7 sont repris ici, mais avec un module récepteur 1 ne comportant pas de tuners. En effet, les signaux TV peuvent par exemple provenir d'un magnétoscope, d'un décodeur ou de tout autre appareil 41 comportant des tuners adéquats tels que les tuners 19 et 20. Ainsi, les signaux analogiques sont directement transmis de l'entrée du module récepteur vers le lecteur portable via le câble unique 40. De la même manière, en absence d'un appareil de type 41, on peut directement transférer des signaux radio/TV provenant d'une antenne vers le lecteur portable 2 lorsque ce dernier comporte des tuners adéquats.

Bien sûr, l'invention n'est pas limitée aux exemples qui viennent d'être décrits et de nombreux aménagements peuvent être apportés à ces exemples sans sortir du cadre de l'invention.

## Revendications

1. Système pour enregistrer des signaux audio/vidéo comprenant:
- un module récepteur (1) de signaux audio/vidéo, apte à recevoir des signaux analogiques et numériques, ce module étant doté, si nécessaire, de moyens de conversion des signaux reçus,
- une unité de stockage (2) pour enregistrer sous forme numérique les signaux audio/vidéo provenant desdits moyens de conversion en réponse à une consigne d'enregistrement;
**caractérisé en ce que** ladite unité de stockage est un lecteur portable autonome intégré de manière extractible dans ledit module récepteur.

2. Système selon la revendication 1, **caractérisé en ce que** ledit lecteur portable comprend :
- des moyens de stockage numérique (30),
- des moyens (38) pour restituer les signaux enregistrés,
- des moyens (36, 37) pour visualiser et/ou écouter les signaux audio/vidéo enregistrés, et
- des moyens (39) d'alimentation autonome rechargeables au sein dudit module récepteur.

3. Système selon la revendication 1 ou 2, **caractérisé en ce que** le module récepteur et le lecteur portable comprennent des moyens de connexion métallique pour la communication.

4. Système selon la revendication 1 ou 2, **caractérisé en ce que** le lecteur portable comprend des moyens de communication sans fil avec ledit module récepteur.

5. Système selon la revendication 1 ou 2, **caractérisé en ce que** les moyens de connexion entre le module récepteur et le lecteur portable comprennent un câble unique comportant un faisceau de fils conducteurs pour la transmission de signaux depuis et vers le lecteur portable; l'extrémité du câble, côté lecteur portable, comprenant un connecteur doté de plusieurs fiches destinées à venir en prise avec des fiches correspondantes du lecteur portable.

6. Système selon la revendication 5, **caractérisé en ce que** le module récepteur comprend en outre une entrée d'alimentation apte à recevoir l'alimentation du secteur via un câble d'alimentation, à alimenter le module récepteur et à alimenter le lecteur portable via ledit câble unique.

7. Système selon l'une quelconque des revendications précédentes, **caractérisé en ce que** le lecteur portable comprend une interface de saisie sous la forme d'un écran tactile.

8. Système selon la revendication 7, **caractérisé en ce que** ledit écran tactile est utilisé comme moyen de pointage absolu d'un objet affiché sur cet écran, ce qui correspond à la fonction dite "touch-screen" en langue anglaise.

9. Système selon la revendication 7, **caractérisé en ce que** ledit écran tactile est utilisé comme un pointeur de souris lorsque l'affichage s'effectue sur un écran de télévision, ce qui correspond à la fonction dite "touch-pad" en langue anglaise.

10. Système selon l'une quelconque des revendications précédentes, **caractérisé en ce que** les moyens de stockage comprennent un disque dur.

11. Système selon l'une quelconque des revendications précédentes, **caractérisé en ce que** le lecteur portable comporte au moins un tuner (28) .

12. Système selon l'une quelconque des revendications précédentes, **caractérisé en ce que** des signaux analogiques audio/vidéo reçus par le module récepteur sont directement transmis vers le lecteur portable.

13. Système selon l'une quelconque des revendications précédentes, **caractérisé en ce que** les moyens de conversion comprennent un tuner hertzien (19) associé à un démodulateur audio pour traiter des signaux analogiques provenant d'une antenne TV reliée à une entrée du module récepteur.

14. Système selon l'une quelconque des revendications précédentes, **caractérisé en ce que** les moyens de conversion comprennent un tuner radio (20) pour traiter des signaux analogiques provenant d'une antenne radio reliée à une entrée du module récepteur.

15. Système selon l'une quelconque des revendications précédentes, **caractérisé en ce que** les moyens de conversion comprennent des moyens (18) de décodage de signaux TV numérique reçus par le module récepteur.

16. Système selon l'une quelconque des revendications précédentes, **caractérisé en ce que** les moyens de conversion comprennent des moyens (21) pour convertir des signaux vidéo numériques reçus par le module récepteur en un format compatible avec le module de stockage.

17. Système selon l'une quelconque des revendications précédentes, **caractérisé en ce que** les moyens de conversion comprennent un convertisseur analogique-numérique (23) pour convertir des signaux analogiques reçus par le module récepteur en signaux numériques transmissibles vers le lecteur portable.

18. Système selon l'une quelconque des revendications 1 à 16, **caractérisé en ce que** le lecteur portable comprend un convertisseur analogique-numérique pour convertir des signaux analogiques provenant du module récepteur en signaux numériques destinés à être stockés, ce lecteur portable comprenant en outre une entrée analogique associée audit convertisseur analogique-numérique pour recevoir les signaux analogiques provenant du module récepteur, et une entrée numérique via un connecteur adapté pour recevoir les signaux numériques provenant du module récepteur.

19. Système selon l'une quelconque des revendications précédentes, **caractérisé en ce que** le lecteur portable comprend des moyens (31) de compression numérique pour compresser les signaux audio/vidéo numériques destinés à être stockés.

20. Système selon l'une quelconque des revendications précédentes, **caractérisé en ce que** le lecteur portable comprend des moyens de conversion (29, 31) aptes à convertir les signaux numériques audio/vidéo stockés en des signaux audio/vidéo lisibles par des terminaux de restitution externes.

21. Système selon la revendication 20, **caractérisé en ce que** le module récepteur comprend des moyens de connexion (13, 14) aptes à transmettre les signaux stockés depuis le lecteur portable vers des terminaux (4, 16) de restitution externes.

22. Système selon l'une quelconque des revendications précédentes, **caractérisé en ce que** le module récepteur comprend un module infrarouge (26) pour recevoir des commandes infrarouges et les transmettre vers le lecteur portable.

23. Système selon l'une quelconque des revendications précédentes, **caractérisé en ce que** ladite consigne d'enregistrement provient d'une télécommande distante.

24. Système selon l'une quelconque des revendications 1 à 22, **caractérisé en ce que** ladite consigne d'enregistrement provient d'une programmation mémorisée au sein du module récepteur.

25. Système selon l'une quelconque des revendications 1 à 22, **caractérisé en ce que** ladite consigne d'enregistrement provient d'une programmation mémorisée au sein du lecteur portable.

26. Système selon l'une quelconque des revendications précédentes, **caractérisé en ce que** le module récepteur comprend un logement apte à recevoir partiellement le lecteur portable.
